# EUROPEAN PATENT APPLICATION

(11) **EP 3 748 680 A1**
(43) Date of publication of application: **09.12.2020**
(21) Application number: 18904186.6
(22) Date of filing: 26.02.2018
(51) Int. Cl.: H01L 27/32

(54) **PIXEL ARRANGEMENT STRUCTURE**

(30) Priority: 01.02.2018 CN 201810103217
(71) Applicant: Wuhan China Star Optoelectronics Semiconductor Display Technology Co., Ltd., Wuhan, Hubei 430070 (CN)
(72) Inventor: ZHAO, Yong, Wuhan, Hubei 430070 (CN); SUN, Liang, Wuhan, Hubei 430070 (CN); LI, Haokai, Wuhan, Hubei 430070 (CN)
(74) Representative: Ström & Gulliksson AB
(86) International application number: PCT/CN2018/077253
(87) International publication number: WO 2019/148558

(57) **Abstract**

Provided is a pixel arrangement structure, comprising multiple first pixel rows and multiple second pixel rows alternately arranged. Each of the first pixel rows comprise multiple first sub-pixels and multiple second sub-pixels alternately arranged at an interval. Each of the second pixel rows comprises multiple third sub-pixels arranged at an interval. Two first sub-pixels and two second sub-pixels adjacent to a third sub-pixel form a virtual square, and the third sub-pixel is disposed within the virtual square formed by the two first sub-pixels and the two second sub-pixels adjacent thereto. The first sub-pixels have the same area as the second sub-pixels, and the first sub-pixels and the second sub-pixels have an area greater than the area of the third sub-pixels. The pixel arrangement structure is applicable in OLED display panels and is capable of reducing manufacturing complexity of OLED display panels and increasing the service life thereof.

## Description

### FIELD OF INVENTION

The present invention relates to the field of display technologies, and more particularly to a pixel arrangement structure.

### BACKGROUND OF INVENTION

Organic light emitting diode (OLED) display devices have many advantages such as self-luminous, low driving voltage, high luminous efficiency, short response time, high clarity and contrast, nearly 180 degrees viewing angle, wide operating temperature range, flexible display and large area full-color display, and are recognized by the industry as the most promising display devices.

OLED display devices generally include a substrate, an anode disposed on the substrate, a hole injection layer disposed on the anode, a hole transport layer disposed on the hole injection layer, a light emitting layer disposed on the hole transport layer, an electron transport layer disposed on the light emitting layer, an electron injection layer disposed on the electron transport layer, and a cathode disposed on the electron injection layer. The principle of light emission of the OLED display devices is that a semiconductor material and an organic light emitting material are driven by an electric field to cause light emission through carrier injection and recombination. In details, the OLED display devices generally use an indium tin oxide (ITO) pixel electrode and a metal electrode as the anode and the cathode of the device, respectively. Driven by a certain voltage, electrons and holes are injected into the electron transport layer and hole transport layer from the cathode and the anode, respectively. The electrons and holes migrate to the light emitting layer through the electron transport layer and the hole transport layer, respectively, and meet in the light emitting layer to form excitons and excite light emitting molecules, which emit visible light after radiation relaxation.

With the development of display technologies, people have higher and higher requirements on resolution and brightness of display devices. To make a high-resolution OLED display requires a higher precision fine metal mask (FMM). In a pixel composed of ordinary stripe sub-pixels (RGB stripe), three sub-pixels are arranged within a pixel pitch in a direction perpendicular to a sub-pixel stripe direction. When a pixel density is greater than 300 ppi, it is very difficult to realize an FMM process at this stage. In addition, due to the improvement of resolution, a distance between a light emitting areas of the sub-pixels is required to be smaller and smaller, and color mixing of an evaporated screen will become more and more serious, especially conventional stripe arrangement of red (R), green (G), and blue (B) three sub-pixels. A length of an opening area of the FMM corresponding to each sub-pixel is long, it is difficult to control the linearity, and color mixing is likely to occur. If the conventional RGB strip pixel structure is directly applied to the OLED panel, there is an issue that the resolution cannot be improved and the production is difficult.

### SUMMARY OF INVENTION

An object of the present invention is to provide a pixel arrangement structure, which is applicable in an organic light emitting diode (OLED) display panel, which can reduce difficulty of manufacturing the OLED display panel and extend lifetime of the OLED display panel.

To achieve the above objective, the present invention provides a pixel arrangement structure comprising a plurality of first pixel rows and a plurality of second pixel rows arranged alternately.

Each first pixel row comprises a plurality of first sub-pixels and a plurality of second sub-pixels arranged alternately and at intervals, and each second pixel row comprises a plurality of third sub-pixels arranged at intervals.

Two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel.

Optionally, shapes of the first sub-pixel, the second sub-pixel, and the third sub-pixel are all square.

Optionally, a shape of the third sub-pixel is a circle.

Optionally, the first sub-pixel and the second sub-pixel both comprise four first sides and four second sides, and the first sides and the second sides are alternately connected to form a closed figure.

Optionally, the first side is an arc recessed toward an inside of the closed figure, and the second side is a straight line.

Optionally, the first side is an arc recessed toward an inside of the closed figure, and the second side is an arc protruding toward an outside of the closed figure. The four first sides have different radii of curvature, and the four second sides have different radii of curvature.

Optionally, diagonal lines of each first sub-pixel and each second sub-pixel in each first pixel row are on a same straight line, and a diagonal line of the third sub-pixel is parallel to a diagonal line of the first sub-pixel.

Optionally, a center of the first sub-pixel coincides with a first vertex of the virtual box, a center of the second sub-pixel coincides with a second vertex adjacent to the first vertex of the virtual box, and a center of the third sub-pixel coincides with a center of the virtual box.

Optionally, the first sub-pixel, the second sub-pixel, and the third sub-pixel have different colors and are one of a red sub-pixel, a blue sub-pixel, and a green sub-pixel.

Optionally, the four first sides of each first sub-pixel are respectively opposite to four third sub-pixels adjacent to the first sub-pixel, and the four first sides of each second sub-pixel are respectively opposite to four third sub-pixels adjacent to the second sub-pixel.

Optionally, a distance from the first side of the first sub-pixel to an edge of the third sub-pixel opposite to the first side thereof and a distance from the first side of the second sub-pixel to an edge of the third sub-pixel opposite to the first side thereof are both a first length, a distance from a center of the first sub-pixel to the first side thereof and a distance from a center of the second sub-pixel to the first side thereof are both a second length, and a radius of the third sub-pixel is a third length.

A pixel density of the pixel arrangement structure ranges from 200 ppi to 600 ppi, the first length ranges from 10 um to 30 um, the second length ranges from 10 um to 50 um, and the third length ranges from 4 um to 40 um.

The present invention further provides a pixel arrangement structure comprising a plurality of first pixel rows and a plurality of second pixel rows arranged alternately.

Each first pixel row comprises a plurality of first sub-pixels and a plurality of second sub-pixels arranged alternately and at intervals, and each second pixel row comprises a plurality of third sub-pixels arranged at intervals.

Two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel.

A shape of the third sub-pixel is a circle.

The first sub-pixel and the second sub-pixel both comprise four first sides and four second sides, and the first sides and the second sides are alternately connected to form a closed figure.

The first side is an arc recessed toward an inside of the closed figure, and the second side is a straight line.

A center of the first sub-pixel coincides with a first vertex of the virtual box, a center of the second sub-pixel coincides with a second vertex adjacent to the first vertex of the virtual box, and a center of the third sub-pixel coincides with a center of the virtual box.

Beneficial effects of the present invention: the present invention provides a pixel arrangement structure comprising a plurality of first pixel rows and a plurality of second pixel rows arranged alternately. Each first pixel row comprises a plurality of first sub-pixels and a plurality of second sub-pixels arranged alternately and at intervals, and each second pixel row comprises a plurality of third sub-pixels arranged at intervals. Two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel. The pixel arrangement structure is applicable in an OLED display panel, which can reduce difficulty of manufacturing the OLED display panel and extend lifetime of the OLED display panel.

### DESCRIPTION OF DRAWINGS

In order to further understand features and technical content of the present invention, refer to the following detailed description and drawings of the present invention. However, the drawings are provided for reference and explanation only, and are not intended to limit the present invention.

In the drawings:
FIG. 1 is a schematic diagram of a pixel arrangement structure according to a first embodiment the present invention.
FIG. 2 is a schematic diagram of a pixel arrangement structure according to a second embodiment of the present invention.
FIG. 3 is a schematic diagram of a first arrangement of a pixel arrangement structure according to a third embodiment of the present invention.
FIG. 4 is a schematic diagram of a second arrangement of the pixel arrangement structure according to the third embodiment of the present invention.
FIG. 5 is a schematic diagram comparing the pixel arrangement structure according to the first embodiment of the present invention with an existing embodiment.
FIG. 6 is a schematic diagram comparing the pixel arrangement structure according to the first embodiment of the present invention with another existing embodiment.
FIG. 7 is a schematic diagram comparing the pixel arrangement structure according to the second embodiment of the present invention with the first embodiment.

### DETAILED DESCRIPTION OF PREFERRED EMBODIMENTS

In order to further elaborate on the technical means and effects adopted by the present invention, the following will describe in detail with reference to the preferred embodiments and the accompanying drawings of the present invention.

The present invention provides a pixel arrangement structure, which is mainly applicable in an organic light emitting diode (OLED) display panel to reduce difficulty of manufacturing the OLED display panel and extend lifetime of the OLED display panel.

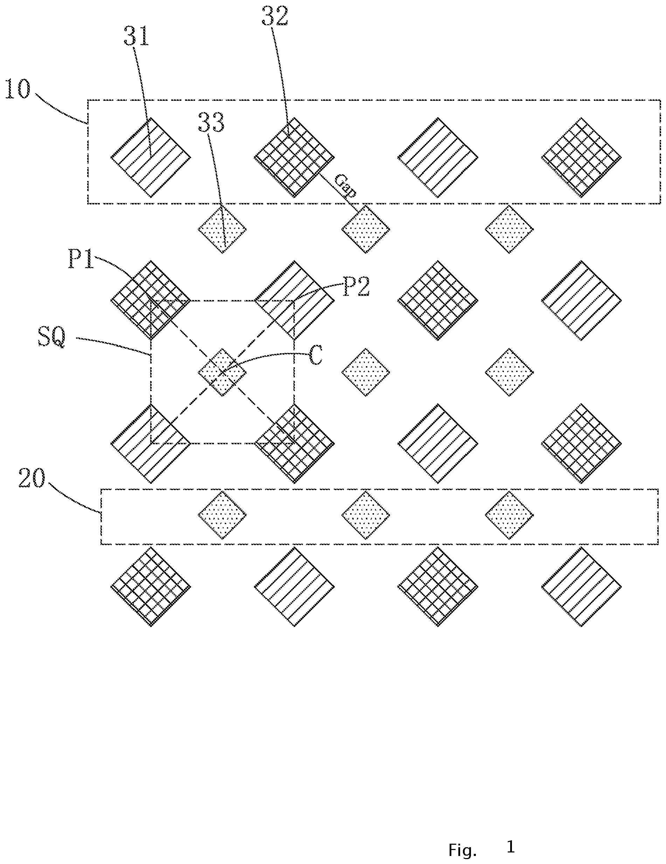

Referring to FIG. 1, in a pixel arrangement structure according to a first embodiment of the present invention, the pixel arrangement structure comprises a plurality of first pixel rows 10 and a plurality of second pixel rows 20 arranged alternately. Each first pixel row 10 comprises a plurality of first sub-pixels 31 and a plurality of second sub-pixels 32 arranged alternately and at intervals, and each second pixel row comprises a plurality of third sub-pixels 33 arranged at intervals. Two first sub-pixels 31 and two second sub-pixels 32 adjacent to the third sub-pixel 33 form a virtual box SQ, and the third sub-pixel 33 is arranged in the virtual box SQ formed by the two first sub-pixels 31 and the two second sub-pixels 32 adjacent thereto, an area of the first sub-pixel 31 is same as an area of the second sub-pixel 32, and the area of the first sub-pixel 31 and the area of the second sub-pixel 32 are greater than an area of the third sub-pixel 33.

In details, as illustrated in FIG. 1, in the first embodiment, a center of the first sub-pixel 31 coincides with a first vertex P1 of the virtual box SQ, a center of the second sub-pixel 32 coincides with a second vertex P2 adjacent to the first vertex P1 of the virtual box SQ, and a center of the third sub-pixel 33 coincides with a center C of the virtual box SQ.

Further, shapes of the first sub-pixel 31, the second sub-pixel 32, and the third sub-pixel 33 are all square, and diagonal lines of each first sub-pixel 31 and each second sub-pixel 32 in each first pixel row 10 are on a same straight line, and a diagonal line of the third sub-pixel 33 is parallel to a diagonal line of the first sub-pixel 31. Therefore, four first sides of each first sub-pixel 31 are respectively opposite to four third sub-pixels 33 adjacent thereto, four first sides of each second sub-pixel 32 are respectively opposite to four third sub-pixels 33 adjacent thereto, and four first sides of each third sub-pixel 33 are respectively opposite to two first sub-pixels 31 and two second sub-pixels 32 adjacent thereto.

Preferably, the first sub-pixel 31, the second sub-pixel 32, and the third sub-pixel 33 have different colors and are one of a red sub-pixel, a blue sub-pixel, and a green sub-pixel. In the first embodiment, the first sub-pixel 31, the second sub-pixel 32, and the third sub-pixel 33 emit red light, blue light, and green light respectively. Corresponding to the OLED display panel, that is, the first sub-pixel 31, the second sub-pixel 32, and the third sub-pixel 33 comprise organic light emitting diodes that emit red light, blue light, and green light, respectively. It is understood that, in other embodiments of the present invention, the first sub-pixel 31, the second sub-pixel 32, and the third sub-pixel 33 may also emit light of other colors.

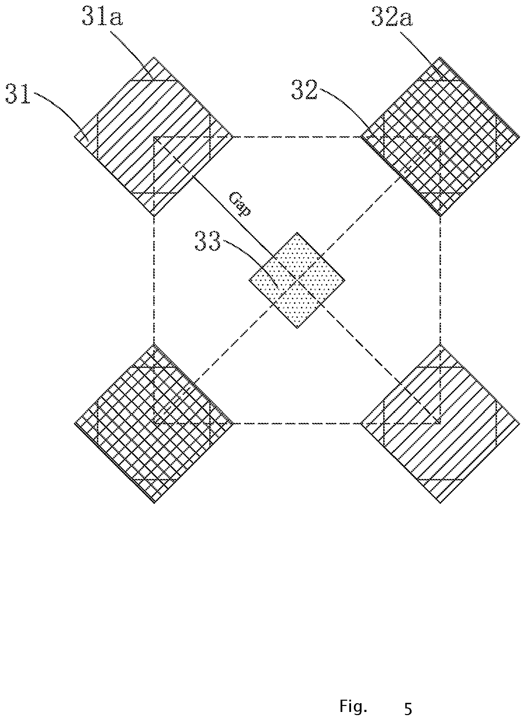

It is noted that square sub-pixels in this embodiment have advantages over octagonal sub-pixels. As illustrated in FIG. 5, compared to shapes of a first sub-pixel 31a and a second sub-pixel 32a being octagonal, and a shape of a third sub-pixel being a square, a distance between the first sub-pixel 31a and the third sub-pixel and a distance between the second sub-pixel 32a and the third sub-pixel are both a first length Gap. As illustrated in FIG. 5, under the same first length Gap, an embodiment of the present invention increases an area of the first sub-pixel 31 and an area of the second sub-pixel 32 by setting both the first sub-pixel 31 and the second sub-pixel 32 to be square. Corresponding to the OLED display panel, an area of an organic light emitting diode is proportional to its lifetime, so that compared with the embodiment using the octagonal first sub-pixel 31a and the octagonal second sub-pixel 32a, the pixel arrangement of the first embodiment of the present invention has a longer lifetime without changing the first length.

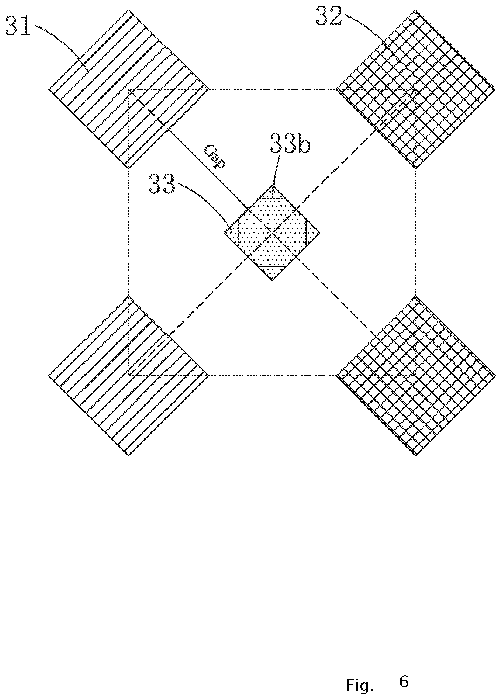

Similarly, referring to FIG. 6, compared with the embodiment where shapes of the first sub-pixel and the second sub-pixel are both square, and the shape of the third sub-pixel 33b is octagonal, in an embodiment of the present invention same as the previous embodiment, by setting the shape of the third sub-pixel 33 to be square, the area of the third sub-pixel is increased and lifetime of the OLED display panel is increased without changing the first length GAP.

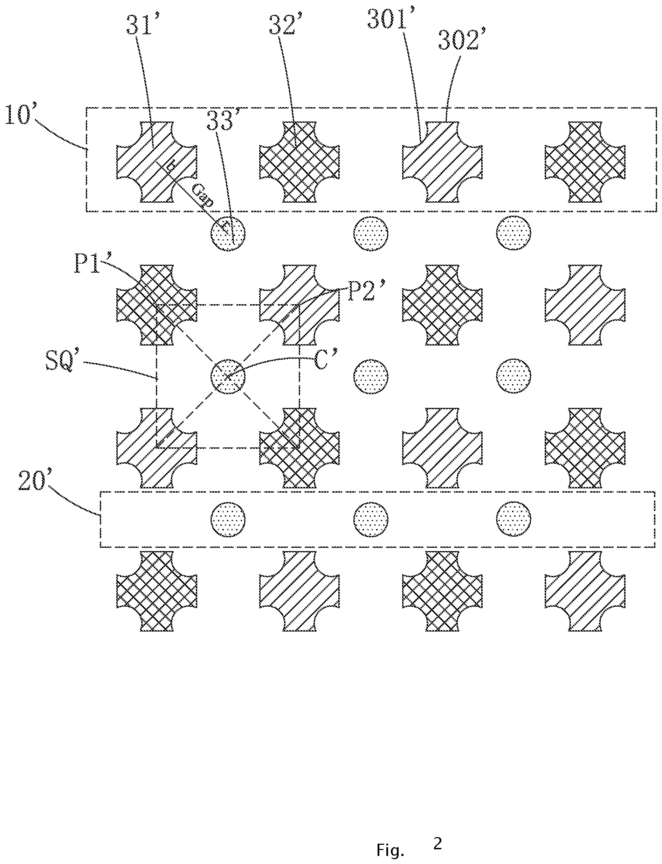

Referring to FIG. 2, in a pixel arrangement structure according to a second embodiment of the present invention, the pixel arrangement structure comprises a plurality of first pixel rows 10' and a plurality of second pixel rows 20' arranged alternately. Each first pixel row 10' comprises a plurality of first sub-pixels 31' and a plurality of second sub-pixels 32' arranged alternately and at intervals, and each second pixel row comprises a plurality of third sub-pixels 33' arranged at intervals. Two first sub-pixels 31' and two second sub-pixels 32' adjacent to the third sub-pixel 33' form a virtual box SQ', and the third sub-pixel 33' is arranged in the virtual box SQ' formed by the two first sub-pixels 31' and the two second sub-pixels 32' adjacent thereto, an area of the first sub-pixel 31' is same as an area of the second sub-pixel 32', and the area of the first sub-pixel 31' and the area of the second sub-pixel 32' are greater than an area of the third sub-pixel 33'.

In details, as illustrated in FIG. 2, in the second embodiment, a center of the first sub-pixel 31' coincides with a first vertex P1' of the virtual box SQ', a center of the second sub-pixel 32' coincides with a second vertex P2' adjacent to the first vertex P1' of the virtual box SQ', and a center of the third sub-pixel 33' coincides with a center C' of the virtual box SQ'. A shape of the third sub-pixel 33' is a circle. The first sub-pixel 31' and the second sub-pixel 32' both comprise four first sides 301' and four second sides 302', and the first sides 301' and the second sides 302' are alternately connected to form a closed figure. The first side 301' is an arc recessed toward an inside of the closed figure, and the second side 302' is a straight line. Therefore, four first sides 301' of each first sub-pixel 31' are respectively opposite to four third sub-pixels 33' adjacent to the first sub-pixel 31', four first sides 301' of each second sub-pixel 32' are respectively opposite to four third sub-pixels 33' adjacent to the second sub-pixel 32'.

It is worth mentioning that, in an ideal state of the second embodiment of the pixel arrangement structure, shapes of the first sub-pixel 31' and the second sub-pixel 32' should be exactly the same, and radii of curvature of four first sides 301' of each first sub-pixel 31' and each second sub-pixel 32' are also the same. In an actual manufacturing process of the second embodiment of the pixel arrangement structure, due to existence of manufacturing errors (for example, manufacturing errors caused by different states of a vapor deposition machine), shapes of the first sub-pixel 31' and the second sub-pixel 32' may be slightly different, and radii of curvature of four first sides 301' of each first sub-pixel 31' and each second sub-pixel 32' may also be slightly deviated, which will not affect the implementation of the present invention.

It should be noted that, in an actual production of FMM, it is difficult to produce square or pointed graphics regardless of etching or laser. In an embodiment of the present invention, the third sub-pixel 33' is set to a circle, and arc-shaped first sides 301' are set in the first sub-pixel 31' and the second sub-pixel 32', which is more in line with the principle of diffusion and can effectively reduce difficulty of making the FFM. In addition, the circular third sub-pixel 33' is the shape with the smallest side length and the highest efficiency in the same area. Due to halo effect of human eyes, a tiny non-circular luminous body will also be regarded as an approximately circular shape. Setting the third sub-pixel 33' as a circular shape can maximize efficiency of the third sub-pixel 33' and meet the halo effect of human eyes. By setting the four first sides 301' of each first sub-pixel 31' to be respectively opposite to four third sub-pixels 33' adjacent to the first sub-pixel 31' and by setting the four first sides 301' of each second sub-pixel 32' to be respectively opposite to the four third sub-pixels 33' adjacent to the second sub-pixel 32', spacing between sub-pixels is maximized.

Preferably, the first sub-pixel 31', the second sub-pixel 32', and the third sub-pixel 33' have different colors and are one of a red sub-pixel, a blue sub-pixel, and a green sub-pixel. In the second embodiment, the first sub-pixel 31', the second sub-pixel 32', and the third sub-pixel 33' emit red light, blue light, and green light respectively. Corresponding to the OLED display panel, that is, the first sub-pixel 31', the second sub-pixel 32', and the third sub-pixel 33' comprise organic light emitting diodes that emit red light, blue light, and green light, respectively. It is understood that, in other embodiments of the present invention, the first sub-pixel 31', the second sub-pixel 32', and the third sub-pixel 33' may also emit light of other colors.

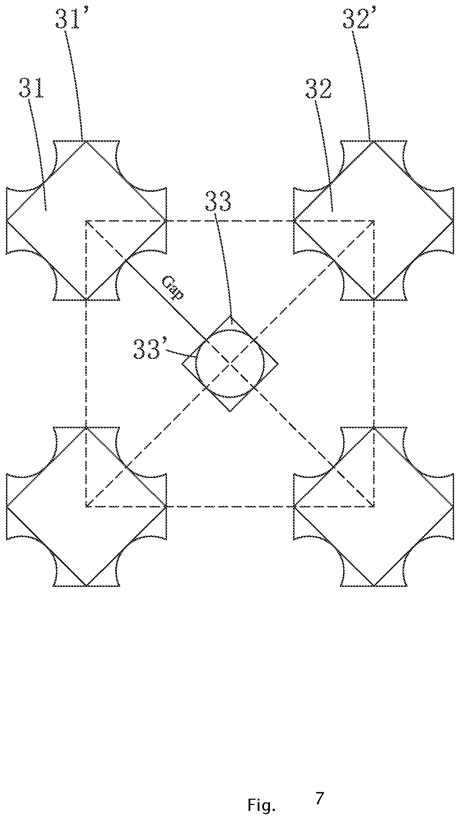

Further, as illustrated in FIG. 7, compared with the first embodiment, in the second embodiment, when a distance between the first sub-pixel and the third sub-pixel and a distance between the second sub-pixel and the third sub-pixel, i.e., the first length Gap, are constant, areas of the first sub-pixel 31' and the second sub-pixel 32' are larger, but the area of the third sub-pixel 33' is smaller. In the OLED display panel, lifetime of an organic light emitting diode emitting blue light is the worst, while lifetime of an organic light emitting diode emitting green light is better. The overall lifetime of the OLED display panel depends on the organic light emitting diode with the worst lifetime. In the second embodiment of the present invention, although the area of the third sub-pixel 33' becomes smaller, the third sub-pixel 33' corresponds to an organic light emitting diode that emits green light, and the second sub-pixel 32' corresponds to an organic light emitting diode that emits blue light. In an actual implementation, actual lifetime of the third sub-pixel 33' after the area thereof becomes smaller is still greater than actual lifetime of the second sub-pixel 32' after the area thereof becomes larger. Therefore, the overall lifetime of the OLED display panel still depends on the actual lifetime of the second sub-pixel 32'. The area of the second sub-pixel 32' is larger than that of the first embodiment, so that the overall lifetime of the OLED display panel is larger than that of the first embodiment.

In details, in the second embodiment of the present invention, a distance from the first side of the first sub-pixel 31' to an edge of the third sub-pixel 33' opposite to the first side 301' thereof and a distance from the first side 301' of the second sub-pixel 32' to an edge of the third sub-pixel 33' opposite to the first side 301' thereof are both a first length Gap, a distance from a center of the first sub-pixel 31' to the first side 301' thereof and a distance from a center of the second sub-pixel 32' to the first side 301' thereof are both a second length b, and a radius of the third sub-pixel 33' is a third length r.

During specific implementation, in order to make the actual lifetime of the third sub-pixel 33' after the area thereof becomes smaller still greater than the actual lifetime of the second sub-pixel 32' after the area thereof becomes larger, thereby extending the overall lifetime of the OLED display panel, a pixel density of the pixel arrangement structure preferably ranges from 200 ppi to 600 ppi, the first length Gap preferably ranges from 10 um to 30 um, the second length b preferably ranges from 10 um to 50 um, and the third length r preferably ranges from 4 um to 40 um.

Optionally, in a specific implementation of the second embodiment of the present invention, the first length Gap may be 20 um, the pixel density of the pixel arrangement may be 200 ppi, a sum of the second length b and the third length r may be 40 um, and the second length b may range from 10 um to 30 um.

Optionally, in another specific implementation of the second embodiment of the present invention, the first length Gap may be 20 um, the pixel density of the pixel arrangement structure may be 250 ppi, a sum of the second length b and the third length r may be 28 um, and the second length b may range from 10 um to 21 um.

Optionally, in yet another specific implementation of the second embodiment of the present invention, the first length Gap may be 20 um, the pixel density of the pixel arrangement structure may be 300 ppi, a sum of the second length b and the third length r may be 20 um, and the second length b may range from 10 um to 15 um.

Optionally, in yet another specific implementation of the second embodiment of the present invention, the first length Gap may be 20 um, the pixel density of the pixel arrangement structure may be 350 ppi, a sum of the second length b and the third length r may be 14 um, and the second length b may be 10 um.

Optionally, in yet another specific implementation of the second embodiment of the present invention, the first length Gap may be 15 um, the pixel density of the pixel arrangement structure may be 200 ppi, a sum of the second length b and the third length r may be 45 um, and the second length b may range from 10 um to 33 um.

Optionally, in yet another specific implementation of the second embodiment of the present invention, the first length Gap may be 15 um, the pixel density of the pixel arrangement structure may be 250 ppi, a sum of the second length b and the third length r may be 33 um, and the second length b may range from 10 um to 24 um.

Optionally, in yet another specific implementation of the second embodiment of the present invention, the first length Gap may be 15 um, the pixel density of the pixel arrangement structure may be 300 ppi, a sum of the second length and the third length may be 25um, and the second length b may range from 10 um to 18 um.

Optionally, in yet another specific implementation of the second embodiment of the present invention, the first length Gap may be 15 um, the pixel density of the pixel arrangement structure may be 350 ppi, a sum of the second length b and the third length r may be 19 um, and the second length b may range from 10 um to 14 um.

Optionally, in yet another specific implementation of the second embodiment of the present invention, the first length Gap may be 15 um, the pixel density of the pixel arrangement structure may be 400 ppi, a sum of the second length b and the third length r may be 15 um, and the second length b may range from 10 um to 11 um.

Optionally, in yet another specific implementation of the second embodiment of the present invention, the first length Gap may be 25 um, the pixel density of the pixel arrangement structure may be 200 ppi, a sum of the second length b and the third length r may be 35 um, and the second length b may range from 10 um to 26 um.

Optionally, in yet another specific implementation of the second embodiment of the present invention, the first length Gap may be 25 um, the pixel density of the pixel arrangement structure may be 250 ppi, a sum of the second length b and the third length r may be 23 um, and the second length b may range from 10 um to 17 um.

Optionally, in yet another specific implementation of the second embodiment of the present invention, the first length Gap may be 25 um, the pixel density of the pixel arrangement structure may be 300 ppi, a sum of the second length b and the third length r may be 15 um, and the second length b may range from 10 um to 11 um.

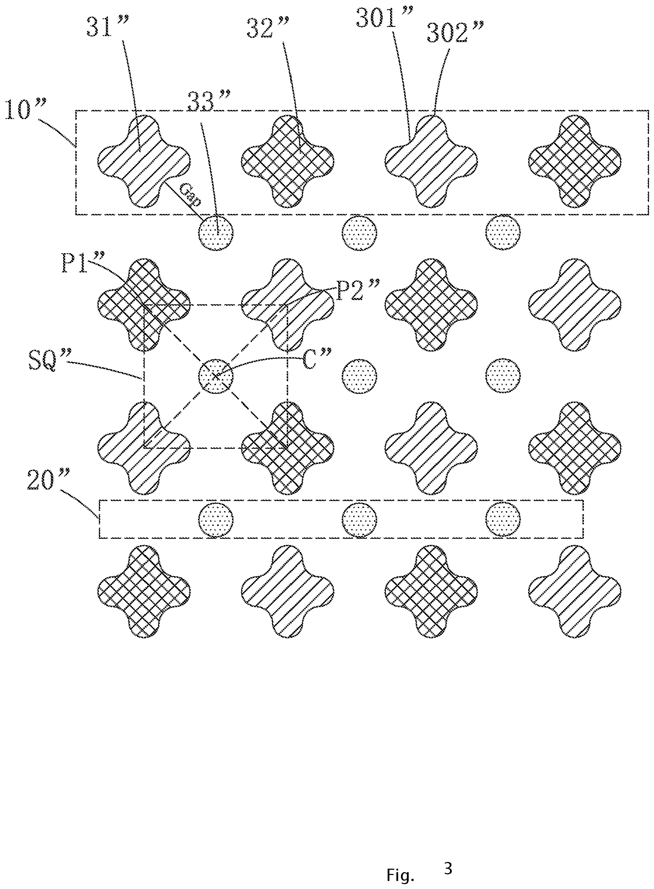

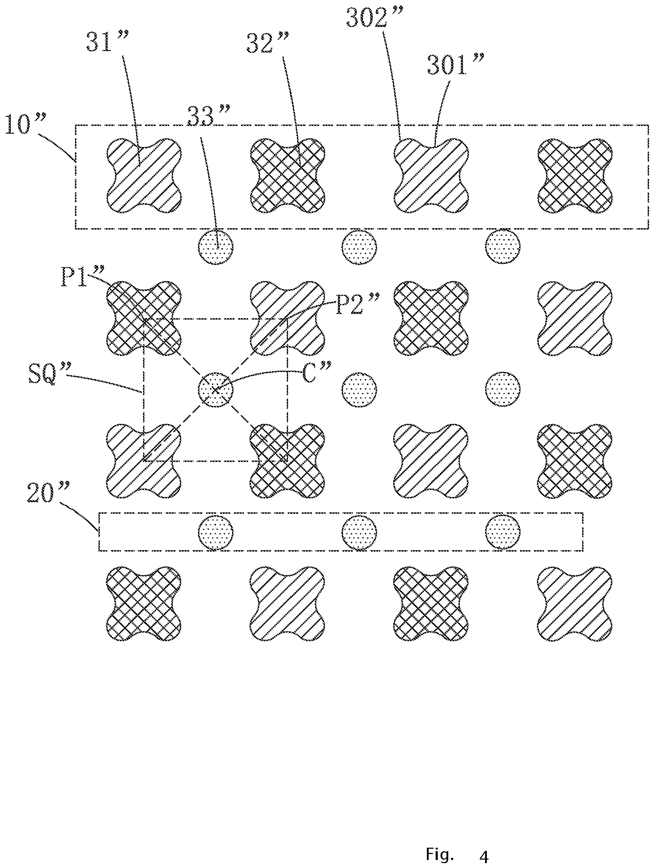

Referring to FIG. 3 and FIG. 4, in a pixel arrangement structure according to a third embodiment of the present invention, the pixel arrangement structure comprises a plurality of first pixel rows 10" and a plurality of second pixel rows 20" arranged alternately. Each first pixel row 10" comprises a plurality of first sub-pixels 31" and a plurality of second sub-pixels 32" arranged alternately and at intervals, and each second pixel row comprises a plurality of third sub-pixels 33" arranged at intervals. Two first sub-pixels 31" and two second sub-pixels 32" adjacent to the third sub-pixel 33" form a virtual box SQ", and the third sub-pixel 33" is arranged in the virtual box SQ" formed by the two first sub-pixels 31" and the two second sub-pixels 32" adjacent thereto, an area of the first sub-pixel 31" is same as an area of the second sub-pixel 32", and the area of the first sub-pixel 31" and the area of the second sub-pixel 32" are greater than an area of the third sub-pixel 33".

In details, as illustrated in FIG. 3 or FIG. 4, in the third embodiment, a center of the first sub-pixel 31" coincides with a first vertex P1" of the virtual box SQ", a center of the second sub-pixel 32" coincides with a second vertex P2" adjacent to the first vertex P1" of the virtual box SQ", and a center of the third sub-pixel 33" coincides with a center C" of the virtual box SQ". A shape of the third sub-pixel 33" is a circle. The first sub-pixel 31" and the second sub-pixel 32" have the same shape and both comprise four first sides 301" and four second sides 302", and the first sides 301" and the second sides 302" are alternately connected to form a closed figure. The first side 301" is an arc recessed toward an inside of the closed figure, and the second side 302" is an arc protruding toward the inside of the closed figure, that is, the shape of the second side 302" is similar to a bow arm of an arrow.

The specific arrangement, as illustrated in FIG. 3, four first sides 301" of each first sub-pixel 31" can be set to be respectively opposite to four third sub-pixels 33" adjacent to the first sub-pixel 31", four first sides 301" of each second sub-pixel 32" can be set to be respectively opposite to four third sub-pixels 33" adjacent to the second sub-pixel 32". Alternatively, as illustrated in FIG. 4, four second sides 302" of each first sub-pixel 31" are set to be respectively opposite to four third sub-pixels 33" adjacent to the first sub-pixel 31", four second sides 302" of each second sub-pixel 32" are set to be respectively opposite to four third sub-pixels 33" adjacent to the second sub-pixel 32".

It is worth mentioning that, in an ideal state of the third embodiment of the pixel arrangement structure, shapes of the first sub-pixel 31" and the second sub-pixel 32" should be exactly the same, radii of curvature of four first sides 301" of each first sub-pixel 31" and each second sub-pixel 32" are also the same, and radii of curvature of four second sides 302" of each first sub-pixel 31" and each second sub-pixel 32" are also the same. In an actual manufacturing process of the third embodiment of the pixel arrangement structure, due to existence of manufacturing errors (for example, manufacturing errors caused by different states of a vapor deposition machine), shapes of the first sub-pixel 31" and the second sub-pixel 32" may be slightly different, radii of curvature of four first sides 301" of each first sub-pixel 31" and each second sub-pixel 32" may also be slightly deviated, and radii of curvature of four second sides 302" of each first sub-pixel 31" and each second sub-pixel 32" may also be slightly deviated, which will not affect the implementation of the present invention.

It should be noted that, in an actual production of FMM, it is difficult to produce square or pointed graphics regardless of etching or laser. In an embodiment of the present invention, the third sub-pixel 33" is set to a circle, and arc-shaped first sides 301" and arc-shaped second sides 302" are set in the first sub-pixel 31" and the second sub-pixel 32", which is more in line with the principle of diffusion and can effectively reduce difficulty of making the FFM. In addition, the circular third sub-pixel 33" is the shape with the smallest side length and the highest efficiency in the same area. Due to halo effect of human eyes, a tiny non-circular luminous body will also be regarded as an approximately circular shape. Setting the third sub-pixel 33" as a circular shape can maximize efficiency of the third sub-pixel 33" and meet the halo effect of human eyes.

Preferably, the first sub-pixel 31", the second sub-pixel 32", and the third sub-pixel 33" have different colors and are one of a red sub-pixel, a blue sub-pixel, and a green sub-pixel. In the third embodiment, the first sub-pixel 31", the second sub-pixel 32", and the third sub-pixel 33" emit red light, blue light, and green light respectively. Corresponding to the OLED display panel, that is, the first sub-pixel 31", the second sub-pixel 32", and the third sub-pixel 33" comprise organic light emitting diodes that emit red light, blue light, and green light, respectively. It is understood that, in other embodiments of the present invention, the first sub-pixel 31", the second sub-pixel 32", and the third sub-pixel 33" may also emit light of other colors.

Further, compared with the second embodiment, in the third embodiment, the second side 302" is an arc protruding toward an outside of the closed figure, so that areas of the first sub-pixel 31" and the second sub-pixel 32" are larger and lifetime can be further improved compared with the second embodiment.

Meanwhile, in each embodiment of the present invention, shapes and areas of the first sub-pixel and the second sub-pixel are completely the same, such that in the manufacturing process of the OLED display panel adopting the pixel arrangement structure of the present invention, the first sub-pixel and the second sub-pixel can be manufactured by using the same metal mask. This reduces production costs and enhances product competitiveness.

In summary, an embodiment of the present invention provides a pixel arrangement structure comprising a plurality of first pixel rows and a plurality of second pixel rows arranged alternately. Each first pixel row comprises a plurality of first sub-pixels and a plurality of second sub-pixels arranged alternately and at intervals, and each second pixel row comprises a plurality of third sub-pixels arranged at intervals. Two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel. The pixel arrangement structure is applicable in an OLED display panel, which can reduce difficulty of manufacturing the OLED display panel and extend lifetime of the OLED display panel.

As mentioned above, those of ordinary skill in the art can make various other corresponding changes and modifications according to technical solutions and technical concepts of the present invention, and all such changes and modifications should fall within the protection scope of the claims of the present invention.

## Claims

1. A pixel arrangement structure, comprising:
a plurality of first pixel rows and a plurality of second pixel rows arranged alternately; wherein:
each first pixel row comprises a plurality of first sub-pixels and a plurality of second sub-pixels arranged alternately and at intervals, and each second pixel row comprises a plurality of third sub-pixels arranged at intervals; and
two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel.

2. The pixel arrangement structure according to Claim 1, wherein shapes of the first sub-pixel, the second sub-pixel, and the third sub-pixel are all square.

3. The pixel arrangement structure according to Claim 1, wherein a shape of the third sub-pixel is a circle.

4. The pixel arrangement structure according to Claim 3, wherein the first sub-pixel and the second sub-pixel both comprise four first sides and four second sides, and the first sides and the second sides are alternately connected to form a closed figure.

5. The pixel arrangement structure according to Claim 4, wherein the first side is an arc recessed toward an inside of the closed figure, and the second side is a straight line.

6. The pixel arrangement structure according to Claim 4, wherein the first side is an arc recessed toward an inside of the closed figure, and the second side is an arc protruding toward an outside of the closed figure.

7. The pixel arrangement structure according to Claim 6, wherein the four first sides have different radii of curvature, and the four second sides have different radii of curvature.

8. The pixel arrangement structure according to Claim 2, wherein diagonal lines of each first sub-pixel and each second sub-pixel in each first pixel row are on a same straight line, and a diagonal line of the third sub-pixel is parallel to a diagonal line of the first sub-pixel.

9. The pixel arrangement structure according to Claim 1, wherein a center of the first sub-pixel coincides with a first vertex of the virtual box, a center of the second sub-pixel coincides with a second vertex adjacent to the first vertex of the virtual box, and a center of the third sub-pixel coincides with a center of the virtual box.

10. The pixel arrangement structure according to Claim 1, wherein the first sub-pixel, the second sub-pixel, and the third sub-pixel have different colors and are one of a red sub-pixel, a blue sub-pixel, and a green sub-pixel.

11. The pixel arrangement structure according to Claim 5, wherein the four first sides of each first sub-pixel are respectively opposite to four third sub-pixels adjacent to the first sub-pixel, and the four first sides of each second sub-pixel are respectively opposite to four third sub-pixels adjacent to the second sub-pixel.

12. The pixel arrangement structure according to Claim 11, wherein a distance from the first side of the first sub-pixel to an edge of the third sub-pixel opposite to the first side thereof and a distance from the first side of the second sub-pixel to an edge of the third sub-pixel opposite to the first side thereof are both a first length, a distance from a center of the first sub-pixel to the first side thereof and a distance from a center of the second sub-pixel to the first side thereof are both a second length, and a radius of the third sub-pixel is a third length; and
a pixel density of the pixel arrangement structure ranges from 200 ppi to 600 ppi, the first length ranges from 10 um to 30 um, the second length ranges from 10 um to 50 um, and the third length ranges from 4 um to 40 um.

13. A pixel arrangement structure, comprising:
a plurality of first pixel rows and a plurality of second pixel rows arranged alternately; wherein:
each first pixel row comprises a plurality of first sub-pixels and a plurality of second sub-pixels arranged alternately and at intervals, and each second pixel row comprises a plurality of third sub-pixels arranged at intervals;
two first sub-pixels and two second sub-pixels adjacent to the third sub-pixel form a virtual box, and the third sub-pixel is arranged in the virtual box formed by the two first sub-pixels and the two second sub-pixels adjacent to the third sub-pixel, an area of the first sub-pixel is same as an area of the second sub-pixel, and the area of the first sub-pixel and the area of the second sub-pixel are greater than an area of the third sub-pixel;
a shape of the third sub-pixel is a circle;
the first sub-pixel and the second sub-pixel both comprise four first sides and four second sides, and the first sides and the second sides are alternately connected to form a closed figure;
the first side is an arc recessed toward an inside of the closed figure, and the second side is a straight line; and
a center of the first sub-pixel coincides with a first vertex of the virtual box, a center of the second sub-pixel coincides with a second vertex adjacent to the first vertex of the virtual box, and a center of the third sub-pixel coincides with a center of the virtual box.

14. The pixel arrangement structure according to Claim 13, wherein the first sub-pixel, the second sub-pixel, and the third sub-pixel have different colors and are one of a red sub-pixel, a blue sub-pixel, and a green sub-pixel.

15. The pixel arrangement structure according to Claim 13, wherein the four first sides of each first sub-pixel are respectively opposite to four third sub-pixels adjacent to the first sub-pixel, and the four first sides of each second sub-pixel are respectively opposite to four third sub-pixels adjacent to the second sub-pixel.

16. The pixel arrangement structure according to Claim 15, wherein a distance from the first side of the first sub-pixel to an edge of the third sub-pixel opposite to the first side thereof and a distance from the first side of the second sub-pixel to an edge of the third sub-pixel opposite to the first side thereof are both a first length, a distance from a center of the first sub-pixel to the first side thereof and a distance from a center of the second sub-pixel to the first side thereof are both a second length, and a radius of the third sub-pixel is a third length; and
a pixel density of the pixel arrangement structure ranges from 200 ppi to 600 ppi, the first length ranges from 10 um to 30 um, the second length ranges from 10 um to 50 um, and the third length ranges from 4 um to 40 um.
